(19) Europäisches Patentamt
European Patent Office
Office européen des brevets

(11) **EP 4 577 842 B1**

(12) **FASCICULE DE BREVET EUROPÉEN**

(45) Date de publication et mention
de la délivrance du brevet:
**06.05.2026   Bulletin 2026/19**

(21) Numéro de dépôt: **23764689.8**

(22) Date de dépôt: **16.08.2023**

(51) Classification Internationale des Brevets (IPC):
***G01R 31/62*** *(2020.01)*

(52) Classification Coopérative des Brevets (CPC):
**G01R 31/62;** G01R 19/02

(86) Numéro de dépôt international:
**PCT/FR2023/051272**

(87) Numéro de publication internationale:
**WO 2024/042290 (29.02.2024 Gazette 2024/09)**

(54) **PROCÉDÉ ET SYSTÈME DE DIAGNOSTIC DE TRANSFORMATEURS DE TENSION**

VERFAHREN UND SYSTEM ZUR DIAGNOSE VON SPANNUNGSWANDLERN

METHOD AND SYSTEM FOR DIAGNOSING VOLTAGE TRANSFORMERS

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité:   **23.08.2022   FR 2208454**

(43) Date de publication de la demande:
**02.07.2025   Bulletin 2025/27**

(73) Titulaire: **Electricité de France**
**75008 Paris (FR)**

(72) Inventeurs:
• **PAYA, Bernard**
**77000 MELUN (FR)**
• **JEANMAIRE, Alain**
**89100 PARON (FR)**

(74) Mandataire: **Regimbeau**
**20, rue de Chazelles**
**75847 Paris Cedex 17 (FR)**

(56) Documents cités:
EP-A1- 2 741 390      CN-A- 108 318 762
CN-A- 111 884 244      CN-A- 113 219 374
CN-U- 203 981 862

## Description

## DOMAINE TECHNIQUE

Le domaine de l'invention est celui des matériels électriques équipant un réseau de transport d'électricité et plus particulièrement celui des transformateurs de tension installés dans les postes électriques à haute tension. L'invention concerne le diagnostic de défauts de tels transformateurs de tension.

## TECHNIQUE ANTÉRIEURE

Des transformateurs de tension sont généralement installés dans les postes électriques à haute tension afin de réduire une tension phase-terre à mesurer à un niveau compatible avec les appareils de mesure, généralement en basse tension. On retrouve notamment, pour une même ligne haute tension triphasée assurant un départ ou une arrivée d'un poste électrique, trois transformateurs de tension chacun connecté à l'une des phases de la ligne haute tension triphasée.

On peut notamment retrouver des transformateurs basés sur la technologie du diviseur capacitif, comme les transformateurs capacitifs de tension répondant par exemple au standard IEC 61869-5 ou encore les transformateurs de tension de faible puissance (connue sous l'acronyme anglo-saxon LPVT pour « Low Power Voltage Transformer ») en montage diviseur capacitif ou diviseur capacitif/résistif, qu'ils soient passifs (par exemple selon le standard IEC 61869-11) ou électroniques (par exemple selon le prochain standard IEC 61869-7).

On peut également retrouver des transformateurs basés sur la technologie du diviseur inductif, comme par exemple ceux répondant au standard IEC 61869-3. Les transformateurs basés sur la technologie du diviseur capacitif sont toutefois généralement préférés aux transformateurs basés sur la technologie du diviseur inductif du fait de leur coût inférieur.

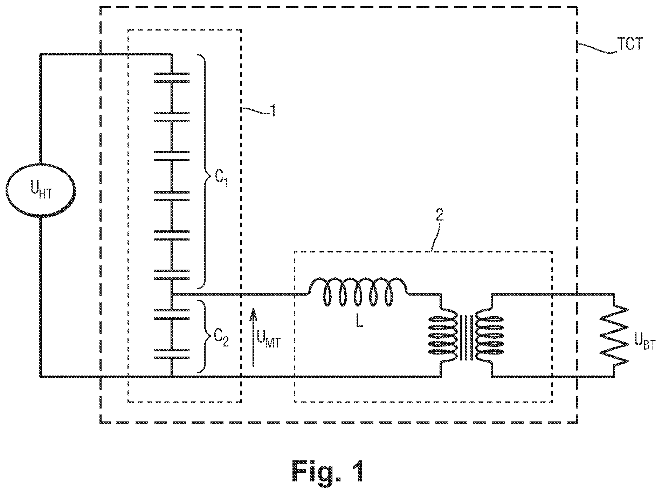

Le principe de fonctionnement d'un transformateur capacitif de tension TCT est illustré par la figure 1. La transformation du TCT est réalisée en deux étapes : d'abord par un diviseur capacitif de tension 1 qui assure la réduction haute tension $U_{HT}$ (également désignée par le terme de tension primaire, en entrée du transformateur) / moyenne tension $U_{MT}$ puis par un transformateur inductif 2 qui assure la compensation du courant réactif et la réduction moyenne tension $U_{MT}$ / basse tension $U_{BT}$ (également désignée par le terme de tension secondaire, en sortie du transformateur). Le diviseur capacitif 1 est constitué d'un empilement de condensateurs unitaires connectés en série, de capacités sensiblement égales, qui sont regroupés en deux blocs : un bloc haute tension C1 comptant N1 condensateurs et un bloc moyenne tension C2 comptant N2 condensateurs. La capacité globale de chaque bloc vaut alors $C_i = \dfrac{C}{N_i}$ avec $i =$

( 1, 2 ) et le rapport de transformation $K_C$ du diviseur capacitif 1 s'exprime selon $K_C = \dfrac{U_{HT}}{U_{MT}} = \dfrac{C_1 + C_2}{C_1}$. Les condensateurs unitaires étant sensiblement identiques, la tension primaire $U_{HT}$ se partage de façon équilibrée entre tous les condensateurs des blocs C1 et C2.

Le mode de dégradation le plus fréquent au cours du temps du transformateur TCT est celui de l'amorçage entre les deux électrodes d'un condensateur entraînant sa mise en court-circuit. Il en résulte une augmentation de la capacité du bloc contenant le condensateur déficient par réduction du nombre $N_i$ de condensateurs actifs, ce qui conduit à une dérive du rapport de transformation $K_C$ du transformateur TCT et, par conséquent, de sa précision. Une défaillance dans le bloc C1 se traduit par une réduction du rapport de transformation $K_C$ et donc par une augmentation de la tension $U_{MT}$ mesurée au travers de l'étage moyenne tension / basse tension. Réciproquement, une défaillance dans le bloc C2 se traduit par une augmentation du rapport de transformation $K_C$ et donc par une réduction de la tension $U_{MT}$ mesurée au travers de l'étage moyenne tension/basse tension. Par ailleurs, la perte d'un condensateur fait que la tension primaire se redistribue entre les condensateurs sains. La tension aux bornes de chaque condensateur sain est alors plus élevée, chaque condensateur sain étant sur-contraint.

Ce mode de dégradation engendre une dérive de précision du TCT qu'il convient de pouvoir maîtriser afin de pouvoir intervenir de façon programmée pour remplacer le TCT défaillant, lors de maintenances par exemple, avant que cette dérive ne prenne trop d'ampleur.

Il est connu que des erreurs dans le pilotage ou la protection d'un réseau électrique peuvent résulter d'une mauvaise évaluation de la tension réelle du réseau. Or en l'occurrence, une dérive d'un TCT peut être interprétée comme un déséquilibre du réseau. Il peut donc en résulter de mauvaises commandes pour tenter de corriger ce déséquilibre.

En particulier, des erreurs dans le comptage d'énergie peuvent se traduire soit par une surévaluation, soit par une sous-évaluation de l'énergie qui transite dans un poste électrique haute tension, selon la localisation du condensateur défaillant venant modifier le rapport de transformation $K_C$ du diviseur capacitif. La normalisation concernant le comptage oblige l'exploitant à utiliser des transformateurs de tension de classe 0,5 (0,5% d'erreur sur l'amplitude du signal) ou plus précise. Les dérives de précision observées sur les TCT défaillants peuvent les faire sortir de la classe de précision requise pour les opérations de comptage et, par conséquent les rendre impropres à cet usage.

On a vu par ailleurs que la dérive de précision s'accompagne d'une sur-contrainte des condensateurs sains qui les rend plus fragiles. Par effet d'emballement, la dégradation du TCT peut s'accélérer, pouvant aller jusqu'à la destruction du TCT, parfois par explosion, et collatéralement celle d'autres matériels présents dans le poste. Il est donc important de pouvoir détecter rapidement les débuts de dérive avant de voir la situation empirer.

La solution imposée par le Gestionnaire du Réseau de Transport d'électricité (GRT) consiste à mesurer la tension secondaire homopolaire, c'est-à-dire la somme instantanée des tensions secondaires des TCT associés chacun à l'une des phases d'une même ligne haute tension triphasée. Au-delà d'un seuil fixé par le GRT, l'utilisateur du réseau de transport a l'obligation de se déconnecter du réseau de transport, le temps d'effectuer le remplacement du TCT défaillant. Le GRT estime en effet qu'une dérive au-delà de ce seuil peut entrainer une dégradation rapide du TCT préjudiciable à la stabilité du réseau électrique auquel il est connecté.

Attendre d'atteindre le seuil d'alarme fixé par le GRT pour remplacer le TCT défaillant oblige l'utilisateur producteur à se déconnecter du réseau durant cette maintenance non programmée pour permettre au GRT de garantir la stabilité du réseau. La durée nécessaire à l'utilisateur producteur pour rétablir sa capacité à fournir l'énergie électrique au réseau de transport conformément aux règles du GRT est de l'ordre de 24 h sous réserve de la disponibilité d'un autre TCT. Pendant cette durée, le GRT doit faire appel à d'autres unités de production non planifiées afin d'assurer l'équilibre entre l'offre et la demande d'électricité. Quant à l'utilisateur consommateur contraint à la déconnexion, il ne dispose plus de l'énergie électrique nécessaire pour son exploitation.

L'étude du fonctionnement des TCT montre qu'il est possible de repérer des dérives de plus faible ampleur qui évitent d'atteindre ce niveau d'alarme. Il est alors possible de continuer à exploiter le TCT défaillant sans contrevenir aux règles du GRT. Le remplacement du TCT peut ainsi être programmé lors d'une phase de maintenance suivant la détection de cette dérive de faible ampleur.

Une solution de diagnostic *ex situ* consiste à démonter les TCT associés à un même départ ou arrivée pour les tester en laboratoire. Cette solution n'est toutefois pas acceptable pour l'utilisateur car elle rend le départ ou l'arrivée concerné inexploitable sur une longue période.

Une autre solution, décrite par exemple dans les demandes internationales WO 2014/162020 A1 et WO 2014/162021 A1, a été développée par la société espagnole Arteche afin de réaliser un diagnostic *in situ* des TCT d'un poste d'interconnexion disposant de plusieurs départs triphasés. Cette solution se base sur la comparaison des signaux secondaires délivrés par les TCT associés à une même phase des différents départs triphasés, ces signaux secondaires étant censés correspondre à un même signal de tension primaire. La dérive d'un TCT par rapport aux autres se traduit par un écart dans le signal secondaire qui est ensuite interprété par un terminal de pilotage de l'ensemble. Cet écart permet alors d'identifier le ou les TCT qui dérivent et l'origine de leur dérive. Pour donner un diagnostic fiable, il est nécessaire de disposer d'au moins trois départs triphasés équipés de TCT ou d'un départ équipé d'un transformateur inductif de tension qui sert alors de référence.

Cette solution de la société espagnole Arteche ne convient pas aux postes ne disposant que d'un seul départ ou arrivée triphasé (poste d'évacuation des unités de production, postes de livraison de clients alimentés en haute tension, etc.). Dans un tel cas de figure, il n'est effectivement pas possible de disposer d'une référence de tension permettant de faire la comparaison avec le TCT à diagnostiquer. Par ailleurs, si pour les postes de petite taille ne disposant que de deux départs (ou arrivées) cette solution permet de détecter s'il y a un problème ou non, elle ne permet toutefois pas d'identifier le TCT défaillant.

On relèvera que les transformateurs LPVT, qui sont basés sur la structure diviseur capacitif ou diviseur capacitif-résistif et ne disposent que d'un seul étage de transformation haute tension / basse tension, peuvent être sujets aux mêmes types de défaillance par amorçage de condensateur unitaire.

Une dérive de précision des transformateurs basés sur la technologie du diviseur inductif est également susceptible de se produire, conséquence d'un défaut dans l'isolation des fils des bobinages des transformateurs venant mettre en court-circuit plusieurs spires d'un bobinage. La valeur de la tension secondaire mesurée peut alors être plus élevée ou plus faible que la tension réelle selon que le défaut apparaît respectivement sur le bobinage primaire ou sur le / l'un des bobinage(s) secondaire(s). Par ailleurs, un courant induit élevé circule dans les spires mises en court-circuit, susceptible de provoquer un échauffement supérieur à ce que le transformateur peut supporter. Il peut s'en suivre des amorçages électriques, une explosion de l'appareil ou un incendie des matériaux diélectriques comme les huiles ou les résines.

CN 108 318 762 A décrit un procédé de surveillance d'un transformateur de tension. Ce procédé comprend une étape de calcul de tensions associées à chacune des phases du transformateur et d'une tension homopolaire. Il comprend ensuite une étape de comparaison de la tension homopolaire à un seuil. Lorsque ce seuil est dépassé, une étape est mise en œuvre pour détecter un éventuel défaut de mise à la terre.

## EXPOSÉ DE L'INVENTION

L'invention a pour objectif de proposer une solution de diagnostic *in situ* de transformateurs de tension équipant un poste électrique haute tension qui puisse permettre de passer outre au moins l'un des inconvénients mentionnés.

Pour ce faire, l'invention propose un procédé de surveillance de transformateurs de tension chacun connecté à l'une des phases d'une même ligne haute tension triphasée, comprenant les étapes suivantes :

- à partir d'une mesure d'une tension secondaire de chacun des transformateurs de tension sur une fenêtre temporelle, détermination d'une tension homopolaire crête de trois tensions efficaces correspondant chacune à la tension efficace de la tension secondaire de l'un des transformateurs de tension ;
- détermination d'une tension efficace de référence à partir des trois tensions efficaces déterminées ;
- lorsque la tension homopolaire crête excède un premier seuil :

   ○ détermination d'un écart entre la tension efficace de référence et celle des trois tensions efficaces déterminées qui est la plus éloignée de la tension efficace de référence;
   ○ détection d'une erreur du transformateur de tension correspondant à celle des trois tensions efficaces déterminées qui est la plus éloignée de la tension efficace de référence lorsque ledit écart est supérieur à une deuxième seuil.

Certains aspects préférés mais non limitatifs de ce procédé sont les suivants :

- la détermination de la tension efficace de référence comprend la détermination des deux tensions efficaces présentant le plus faible écart relatif parmi les trois tensions efficaces déterminées et le calcul de la moyenne desdites deux tensions efficaces ;
- le premier seuil est une fraction de la tension efficace de référence ;
- le deuxième seuil est identique au premier seuil ;
- les transformateurs de tension intègrent chacun un diviseur capacitif de tension ou un diviseur capacitif/résistif de tension qui comprend un étage haute tension et un étage moyenne ou basse tension et l'erreur est attribuée à l'étage haute tension, respectivement à l'étage moyenne ou basse tension, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence ;
- les transformateurs de tension sont des transformateurs inductifs comprenant chacun un enroulement primaire et un enroulement secondaire et dans lequel l'erreur est attribuée à l'enroulement primaire, respectivement à l'enroulement secondaire, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence ;

- il comprend la réitération desdites étapes et la génération d'une alerte lorsqu'une erreur de l'un des transformateurs de tension est détectée lors de plusieurs itérations consécutives desdites étapes ;
- la mesure de la tension secondaire de chacun des transformateurs de tension sur la fenêtre temporelle correspond à un ensemble d'échantillons numériques successifs chacun associé à un niveau de qualité correct ;
- la détermination des trois tensions efficaces comprend la détection des passages à zéro de la tension secondaire mesurée pour chacun des transformateurs de tension sur la fenêtre temporelle.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1, déjà discutée précédemment, est un schéma d'un transformateur capacitif de tension ;
- la figure 2 est un schéma d'un système de diagnostic conforme à une mise en œuvre possible de l'invention ;
- la figure 3 est un algorigramme illustrant une réalisation possible du procédé selon l'invention.

## EXPOSÉ DÉTAILLÉ DE MODES DE RÉALISATION PARTICULIERS

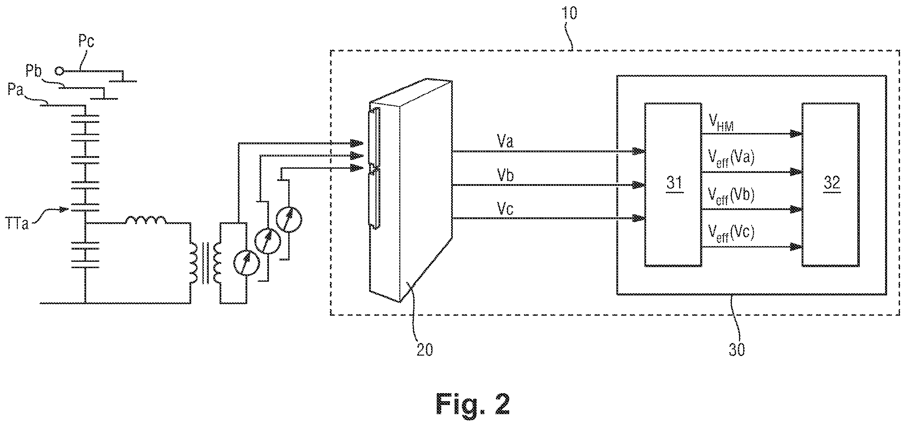

En référence à la figure 2, l'invention porte sur un procédé de surveillance de transformateurs de tension chacun connecté à l'une des phases Pa, Pb, Pc d'une même ligne haute tension triphasée assurant un départ ou une arrivée d'un poste électrique. Par souci de lisibilité, un seul transformateur de tension TTa est représenté sur la figure 2, en l'occurrence un transformateur capacitif de tension associé à la phase Pa. L'invention n'est pas limitée à ce type de transformateur et s'étend également aux transformateurs LPVT en montage diviseur capacitif ou diviseur capacitif/résistif ou encore aux transformateurs inductifs de tension.

Toujours en référence à la figure 2, le procédé selon l'invention est mis en œuvre par un système 10 de diagnostic de défauts des transformateurs de tension. Ce système 10 comprend un appareil de surveillance 30 et, le cas échéant lorsque les transformateurs de tension délivrent un signal analogique, un convertisseur analogique-numérique 20. Les transformateurs de tension délivrant un signal numérique intègrent leur propre convertisseur analogique-numérique auquel est alors couplé l'appareil de surveillance 30. Un tel convertisseur analogique-numérique intégré prend par exemple la forme d'un concentrateur de type MU pour « Merging Unit » apte à délivrer à l'appareil de surveillance 30 un flux de données conforme au protocole IEC 61850-9-2. On prend dans ce qui suit l'exemple de transformateurs à sortie analogique, sans que l'invention ne soit pour autant limitée à ce type de transformateurs.

Le convertisseur analogique-numérique 20 est couplé, d'une part, à un secondaire de chacun des transformateurs de tension et, d'autre part, à l'appareil de surveillance 30. Le convertisseur analogique-numérique 20 est configuré pour convertir en des valeurs échantillonnées les signaux analogiques issus de transformateurs de mesure de tension VTa équipant le secondaire de chacun des transformateurs de tension et pour fournir les valeurs ainsi échantillonnées à l'appareil de surveillance 30.

L'appareil de surveillance 30 comprend un module 31 de calcul de tensions caractéristiques et un module 32 d'interprétation de l'état des transformateurs de tension dont les fonctions seront décrites ci-après. L'appareil de surveillance 30 prend typiquement la forme d'un microcontrôleur dans lequel est implémenté un logiciel de traitement des données issues du convertisseur analogique-numérique 20 afin d'élaborer un diagnostic.

Dans un exemple de réalisation, les transformateurs de tension TTa, chacun associé à l'une des phases Pa, Pb, Pc de la ligne triphasée, sont reliés par leurs sorties secondaires à trois entrées du convertisseur analogique-numérique 20 (typiquement un concentrateur autonome de type SAMU pour « Stand-Alone Merging Unit »). Les signaux des trois entrées sont échantillonnés de manière synchrone par le convertisseur analogique-numérique 20. La fréquence d'échantillonnage peut être adaptée en fonction de la précision de la mesure souhaitée, en particulier si on souhaite prendre en compte finement les harmoniques. Le théorème de Shannon précise que la fréquence d'échantillonnage minimale est le double de la fréquence qu'on veut observer. Les fréquences de 4 000 et 4 800 Hz peuvent notamment être utilisés, qui sont normalisées pour le protocole IEC 61850-9-2 et permettent ainsi d'explorer jusqu'à l'harmonique 40 des réseaux 50 Hz ou 60 Hz.

Les échantillons Va, Vb et Vc résultants de la numérisation des mesures des tensions secondaires des transformateurs de tension peuvent être conditionnés de façon à pouvoir identifier l'instant de l'échantillonnage (par exemple sous forme d'un numéro d'échantillon par rapport à une référence de temps, codé en binaire). Un niveau de qualité peut être associé à chacun de ces échantillons Va, Vb et Vc.

Ces échantillons ainsi conditionnés sont envoyés sous forme de flux de données dans une ligne de transmission de type informatique. Ce flux de données peut être conforme au standard IEC 61850-9-2 relatif à la transmission de valeurs échantillonnées (« Sampled Values » en anglais) et être envoyé dans un bus de terrain Ethernet.

L'utilisation d'un concentrateur autonome de type SAMU conforme à la norme IEC 61869-13 présente les avantages listés ci-après.

Tout d'abord, les tensions d'entrée des voies de mesure des tensions sont compatibles avec les tensions de sortie des transformateurs de tension conformes à la norme IEC 61869-5, norme couramment utilisée dans les postes électriques.

Ensuite, l'impédance d'entrée des voies de mesure des tensions est suffisamment élevée (typiquement de l'ordre du mégohm) pour que la puissance appelée au transformateur de tension soit négligeable devant la puissance de précision dudit transformateur de tension. Le transformateur de tension fonctionne alors à l'intérieur de sa classe de précision telle que définie au § 5.6 de la norme IEC 61869-5 et la connexion du SAMU ne fait pas dériver la précision du réducteur de mesure.

Par ailleurs, la précision de la conversion analogique numérique est identifiée par une classe de précision telle que définie au § 5.6.1302 de la norme IEC 61869-13. Cela permet de garantir que la conversion n'entraine pas de dérive de précision excessive par rapport à celle que l'on veut observer. Les classes de précision typiques sont les classes 0,5 et 0,2 correspondant respectivement à des erreurs en amplitude de $\pm 0,5$ % et $\pm 0,2$ % et des erreurs de déphasage de $\pm 20'$ et $\pm 10'$. Il est bien sûr possible d'utiliser des classes plus précises que la classe 0,2.

Enfin, l'isolement des entrées des transformateurs de mesure du SAMU doit respecter les exigences précisées au § 5.3.1301 de la norme IEC 61869-13. De ce fait, les entrées vont supporter les tensions secondaires résultant des ondes utilisés pour évaluer les niveaux d'isolement exigés par la norme IEC 61869-5 concernant les TCT. Les conditions de fonctionnement en toute sécurité sont ainsi respectées.

L'unité de surveillance 30 est connectée à la ligne de transmission du flux de données de façon à recevoir les données en provenance du convertisseur analogique-numérique 20. L'unité de surveillance 30 est configurée pour décoder les trames des signaux numériques et reconstituer les signaux correspondant aux mesures des tensions secondaires des transformateurs de tension Va, Vb et Vc sous forme de tableaux de valeurs, chaque ligne du tableau correspondant à un instant donné de l'échantillonnage.

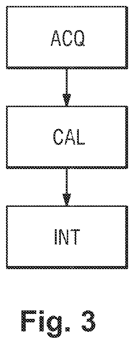

En référence à la figure 3, le procédé selon l'invention comprend une étape d'acquisition ACQ, par le module 31 de calcul de tensions caractéristiques de l'unité de surveillance 30, d'une mesure Va, Vb, Vc d'une tension secondaire de chacun des transformateurs de tension sur une fenêtre temporelle.

Dans un mode de réalisation possible, sur un cycle d'analyse de durée prédéterminée (10 secondes par exemple), l'unité de surveillance 30 sélectionne un sous-ensemble de données pour lequel il a obtenu l'ensemble des échantillons sans erreur c'est-à-dire présentant un niveau de qualité correct sur la fenêtre temporelle (2 secondes d'échantillons par exemple, soit environ 100 périodes du signal 50 Hz). La durée de la fenêtre temporelle est significative des phénomènes qu'on cherche à observer. Elle permet d'éliminer les fluctuations rapides (durée inférieure à la période secteur). Elle laisse par ailleurs suffisamment de temps pour le traitement des données à l'intérieur d'un cycle d'analyse.

Le procédé selon l'invention comprend ensuite une étape CAL de détermination, par le module 31 de calcul de tensions caractéristiques de l'unité de surveillance, d'une tension homopolaire crête $V_{HM}$ et de trois tensions efficaces $V_{eff}(Va)$, $V_{eff}(Vb)$, $V_{eff}(V_C)$ correspondant chacune à la tension efficace de la tension secondaire Va, Vb, Vc de l'un des transformateurs de tension.

Dans un mode de réalisation possible, un filtrage numérique des signaux par un filtre passe-bas (présentant par exemple une fréquence de coupure de 100 Hz) est réalisé préalablement à l'étape CAL afin de limiter le bruit numérique résultant de la conversion analogique numérique.

Lors de l'étape CAL, la détermination de la tension homopolaire crête $V_{HM}$ comprend le calcul de la tension homopolaire instantanée Vh, somme des trois tensions secondaires Va, Vb et Vc, et la détermination de sa valeur crête sur la fenêtre temporelle.

L'étape CAL comprend par ailleurs le calcul de la fréquence du réseau par recherche des passages par zéro des tensions secondaires. Dans un mode de réalisation possible, une ou plusieurs périodes (quatre par exemple) des échantillons à chaque extrémité du sous-ensemble ne sont pas prises en considération ce qui permet d'éliminer les erreurs liées aux effets de bord du filtrage numérique. La détermination des tensions efficaces $V_{eff}(Va)$, $V_{eff}(Vb)$, $V_{eff}(V_C)$ peut être réalisée par intégration sur le plus grand nombre entier de périodes $N_T$ dans le sous-ensemble de données, après éventuelle élimination des périodes aux extrémités, selon

$$V_{eff}(Vx) = \sqrt{\frac{1}{N_T T} \int_0^{N_T T} Vx(t)^2 \, dt}$$ avec $x$ = (a, b, c) et T la durée d'une période.

Le procédé selon l'invention comprend ensuite une étape INT, mise en œuvre par le module 32 d'interprétation de l'état des transformateurs de tension, de détection d'une éventuelle erreur de l'un des transformateurs de tension.

Cette étape INT comprend la détermination d'une tension efficace de référence $V_{err\_M}$ à partir des trois tensions efficaces déterminées $V_{eff}(Va)$, $V_{eff}(Vb)$, $V_{eff}(Vc)$. Dans un mode de réalisation possible, la tension efficace de référence $V_{err\_M}$ correspond à la moyenne des trois tensions efficaces déterminées $V_{eff}(Va)$, $V_{eff}(Vb)$, $V_{eff}(Vc)$. Dans un mode de réalisation privilégié permettant d'accroître la sensibilité du diagnostic, la détermination de la tension efficace de référence $V_{err\_M}$ comprend la détermination des deux tensions efficaces présentant le plus faible écart relatif (en valeur absolue) parmi les trois tensions efficaces déterminées (i.e. les deux tensions efficaces les plus proches) et le calcul de la moyenne desdites deux tensions efficaces.

Dans un mode de réalisation possible, l'étape INT comprend la comparaison de chacune des trois tensions efficaces déterminées à une valeur seuil (correspondant par exemple à un seuil de coupure, tel que 10% d'une tension primaire théorique du réseau) et la détermination de la présence de la tension du réseau sur la ligne électrique haute tension lorsque les valeurs efficaces des trois tensions simples sont toutes supérieures à la valeur seuil. En l'absence de tension de réseau, l'étape INT conclut à l'absence d'erreur.

En présence de tension de réseau, l'étape INT comprend la comparaison de la tension homopolaire crête $V_{HM}$ à un premier seuil. Ce premier seuil peut être fixé par rapport à la tension efficace de référence $V_{eff\_M}$, par exemple 3% de la tension efficace de référence $V_{eff\_M}$.

Si la tension homopolaire crête $V_{HM}$ est inférieure au premier seuil, l'étape INT conclut à l'absence d'erreur. Dans le cas contraire, l'étape INT conclut à la présence d'une erreur. La valeur de ce premier seuil est de préférence choisie nettement inférieure au seuil d'alarme fixé par le GRT mais suffisamment élevée pour s'affranchir des fluctuations naturelles du réseau électrique. Dans le cas d'un transformateur capacitif ou LPVT, ce premier seuil reste significatif d'une défaillance naissante du transformateur car elle permet de détecter l'amorçage d'un seul condensateur unitaire de la colonne du diviseur capacitif

L'identification de celui des trois transformateurs de tension qui est affecté par cette erreur s'opère de la manière suivante.

Lorsque la tension homopolaire crête excède le premier seuil, l'étape INT comprend la détermination d'un écart entre la tension efficace de référence $V_{err\_M}$ et celle des trois tensions efficaces déterminées qui est la plus éloignée de la tension efficace de référence. Dans le mode de réalisation privilégié évoqué précédemment où la tension efficace de référence correspond à la moyenne des deux tensions efficaces les plus proches, celle des trois tensions efficaces déterminées qui est la plus éloignée de la tension efficace de référence est donc la tension efficace non utilisée dans le calcul de cette moyenne.

Cet écart est comparé à un deuxième seuil, qui peut être identique au premier seuil, par exemple 3% de la tension efficace de référence $V_{eff\_M}$.

Si l'écart est inférieur au deuxième seuil, l'étape INT conclut que l'erreur ne peut être attribuée à l'un des trois transformateurs de tension en particulier. L'erreur peut alors être identifiée comme étant une erreur d'angle de phase.

Si l'écart est supérieur au deuxième seuil, l'étape INT détecte une erreur du transformateur de tension correspondant à celle des trois tensions efficaces déterminées qui est la plus éloignée de la tension efficace de référence $V_{eff\_M}$.

Lorsque les transformateurs de tension intègrent chacun un diviseur capacitif de tension ou un diviseur capacitif/résistif de tension qui comprend un étage haute tension et un étage moyenne ou basse tension, l'étape INT peut comprendre l'attribution de l'erreur à l'étage haute tension, respectivement à l'étage moyenne ou basse tension, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence (le rapport de transformation $K_c$ est alors inférieur, respectivement supérieur, au rapport théorique de transformation).

Lorsque les transformateurs de tension sont des transformateurs inductifs comprenant un enroulement primaire et un (ou plusieurs) enroulement(s) secondaire(s), l'étape INT peut comprendre l'attribution de l'erreur à l'enroulement primaire, respectivement à l'enroulement secondaire connecté au système 10 de diagnostic de défauts, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence.

On relèvera que certains transformateurs inductifs disposent de deux enroulements secondaires : l'un est utilisé pour la mesure ou le pilotage, l'autre est utilisé pour la protection. Dans ce cas, un défaut de l'enroulement primaire se voit sur les deux sorties secondaires tandis qu'un défaut d'un enroulement secondaire ne se voit que sur la sortie secondaire correspondante.

Dans une réalisation possible, les étapes du procédé sont réitérées et une alerte est générée lorsqu'une erreur de l'un des transformateurs de tension est détectée lors de plusieurs itérations consécutives desdites étapes (par exemple 6 itérations). L'erreur est ainsi considérée comme étant avérée. Dans le cas contraire, l'étape INT peut conclure que l'erreur détectée résulte d'un phénomène transitoire du réseau électrique et non pas d'une défaillance de l'un des transformateurs de tension.

Les différentes valeurs de tension ainsi que les différents résultats du diagnostic réalisés par le système 10 peuvent être enregistrés dans des fichiers journaux en vue d'une exploitation ultérieure, *ex situ*.

On a vu précédemment que les valeurs numériques peuvent être filtrées numériquement (par exemple par un filtre passe-bas de fréquence de coupure de 100 Hz). Or ce filtrage induit une réduction naturelle des valeurs de tension. Afin de corriger cet effet, un rapport de correction 1/a peut être appliqué aux valeurs de tension enregistrées dans les fichiers journaux où a correspond à la valeur crête en sortie du filtre numérique d'un signal sinusoïdal à la fréquence du réseau (déterminée par la méthode des passages par zéro) présentant avant traitement par le filtre numérique une valeur crête unitaire.

On retiendra que l'invention présente pour originalité le fait que le diagnostic ne se base que sur les signaux des trois phases du réseau triphasé supposées équilibrées. Il ne fait appel à aucun signal de référence extérieur utilisé habituellement pour évaluer la précision du capteur à tester par la comparaison de deux signaux temporels (méthode utilisée dans la norme IEC 61869-5 § 7.2.6 pour réaliser en laboratoire l'essai concernant la précision d'un transformateur capacitif de tension).

Aussi, par opposition à la solution *in situ* développée par la société Arteche, selon l'invention la comparaison des amplitudes des tensions mesurées ne s'effectue pas entre les départs d'une même phase mais entre les trois phases d'un seul départ (ou arrivée) triphasé. Par ailleurs, la solution de la société Arteche compare les valeurs des tensions de plusieurs départs et d'une même phase à chaque instant de l'onde de tension, c'est-à-dire à chaque échantillon synchronisé. En l'absence de dérive, toutes les valeurs doivent être identiques, à la précision du système de diagnostic près. La solution objet de l'invention compare les trois signaux des trois phases qui sont par nature déphasés d'environ 120 ° l'un par rapport aux autres ; la comparaison directe des signaux temporels ne permet pas de réaliser simplement le diagnostic. Le traitement de l'information décrit dans l'invention est requis pour aboutir au résultat recherché.

La mise en place de la solution de la société Arteche nécessite en outre la mise hors tension du poste. Les capteurs de mesure sont installés dans le poste au pied des transformateurs de tension testés et sont raccordés au niveau d'une boite de raccordement secondaire. Pour chaque transformateur de tension testé, il est nécessaire de pénétrer à nouveau dans le poste pour déplacer le capteur de mesure d'un transformateur de tension à l'autre. La mise en place de la solution objet de l'invention peut s'effectuer dans le local de commande de l'exploitant là où arrivent les signaux secondaires des trois phases du départ ou de l'arrivée. La connexion peut ainsi être réalisée dans des conditions de sécurité accrues du fait de l'absence de tensions élevées dans ce local.

Le diagnostic selon l'invention peut en outre être insensible aux fluctuations lentes du réseau (par rapport à la période du réseau) : fluctuations de tension, fluctuations de fréquence. Les fluctuations lentes de tension sont généralement identiques pour les trois phases du réseau et les critères de dérive utilisés dans l'invention reposent sur un écart relatif des tensions entre elles. Les fluctuations lentes de la fréquence sont mesurées par la méthode du passage par zéro des tensions secondaires et la valeur obtenue est prise en compte dans l'évaluation des valeurs efficaces des tensions. Les fluctuations rapides et transitoires du réseau peuvent également être éliminées car, quand bien même elles sont détectées comme erreurs, elles ne génèrent pas d'alertes en raison de leur caractère fugitif. Seules les erreurs ayant un caractère permanent sont retenues.

L'invention permet d'identifier le transformateur défaillant et l'origine de sa défaillance bien avant d'atteindre le seuil requis par le GRT. Il est ainsi possible de continuer à exploiter temporairement le transformateur défaillant et de pouvoir planifier son remplacement lors d'une maintenance programmée du poste. La sensibilité du diagnostic permet aussi de s'affranchir des fluctuations normales du réseau électrique pour ne déclencher des alarmes que lorsque le défaut du transformateur est avéré.

L'invention s'avère particulièrement intéressante pour les postes ne disposant que d'un seul départ (poste d'évacuation du producteur) ou d'une seule arrivée (poste de livraison client) car les autres solutions présentes sur le marché ne peuvent s'appliquer à ces types de postes.

L'invention n'est toutefois pas limitée à une telle architecture et peut également être mise en œuvre afin de réaliser la surveillance de plusieurs départs ou arrivées au sein d'un même poste. Chaque départ ou arrivée triphasé est associé à son convertisseur analogique-numérique triphasé. Pour permettre les comparaisons des différents départs, un signal est envoyé aux différents convertisseurs analogique-numérique pour assurer la synchronisation de l'échantillonnage des voies de mesure entre les convertisseurs analogique-numérique. Les flux de données numériques générées sont envoyés dans une même ligne de transmission ou dans plusieurs lignes de transmission jusqu'à une unique unité de surveillance. Le diagnostic peut alors être affiné en réalisant une inter-comparaison des différents départs ou arrivées triphasés en complément du diagnostic présenté précédemment. L'utilisation de SAMUs évoquée dans le mode de réalisation préféré permet de réaliser cette variante de façon simple, les différentes SAMUs injectant leur flux de données dans le réseau Process Bus sur lequel est aussi connectée l'unité de surveillance. Différents modes de synchronisation sont proposés par la norme IEC 61869-13 ; celle qui est préférée par la norme utilise le réseau Process Bus en appliquant le protocole PTP. Cela évite d'avoir à installer un réseau supplémentaire dédié au signal de synchronisation.

On notera que l'invention s'applique également aux postes numérisés déjà équipés d'un réseau Process Bus distribuant les flux de données « Sampled Values » en provenance de concentrateurs intégrés à des transformateurs LPVT à sortie numérique ou de concentrateurs autonomes SAMU connectés à des transformateurs capacitifs de tension ou des LPVT à sortie analogique. Dans un tel cas de figure, il suffit de connecter l'unité de surveillance à ce même réseau pour pouvoir réaliser le diagnostic objet de l'invention. Cette variante s'applique aussi à des réducteurs de mesure de faible puissance à sortie numérique combinant la mesure de la tension simple (LPVT) et la mesure du courant de phase (LPCT pour « Low Power Current Transformer »).

L'invention n'est pas limitée au procédé précédemment décrit mais s'étend également à un programme d'ordinateur comprenant des instructions qui, lorsque le programme est exécuté par un ordinateur, conduisent celui-ci à mettre en œuvre ce procédé, à un appareil de surveillance comprenant un processeur configuré pour mettre en œuvre ce procédé, ainsi qu'à un système de diagnostic comprenant un convertisseur analogique-numérique et un tel appareil de surveillance, le convertisseur analogique-numérique étant couplé, d'une part, à un secondaire de chacun des transformateurs de tension et, d'autre part, audit appareil de surveillance. L'invention porte également sur un poste électrique haute tension équipé d'un tel système de diagnostic ou d'un tel appareil de surveillance.

## Revendications

1. Procédé de surveillance de transformateurs de tension (TCT, TTa) chacun connecté à l'une des phases (Pa, Pb, Pc) d'une même ligne haute tension triphasée, comprenant les étapes suivantes :

   - à partir d'une mesure d'une tension secondaire de chacun des transformateurs de tension sur une fenêtre temporelle, détermination d'une tension homopolaire crête ($V_{HM}$) et de trois tensions efficaces ($V_{eff}(Va)$, $V_{eff}(Vb)$, $V_{eff}(Vb)$) correspondant chacune à la tension efficace de la tension secondaire (Va, Vb, Vc) de l'un des transformateurs de tension ;
   - détermination d'une tension efficace de référence à partir des trois tensions efficaces déterminées ;
   - lorsque la tension homopolaire crête excède un premier seuil :

     ◦ détermination d'un écart entre la tension efficace de référence et celle des trois tensions efficaces déterminées qui est la plus éloignée de la tension efficace de référence;
     ◦ détection d'une erreur du transformateur de tension correspondant à celle des trois tensions efficaces déterminées qui est la plus éloignée de la tension efficace de référence lorsque ledit écart est supérieur à un deuxième seuil.

2. Procédé selon la revendication 1, dans lequel la détermination de la tension efficace de référence comprend la détermination des deux tensions efficaces présentant le plus faible écart relatif parmi les trois tensions efficaces déterminées et le calcul de la moyenne desdites deux tensions efficaces.

3. Procédé selon l'une des revendications 1 et 2, dans lequel le premier seuil est une fraction de la tension efficace de référence.

4. Procédé selon l'une des revendications 1 à 3, dans lequel le deuxième seuil est identique au premier seuil.

5. Procédé selon l'une des revendications 1 à 4, dans lequel les transformateurs de tension intègrent chacun un diviseur capacitif de tension ou un diviseur capacitif/résistif de tension qui comprend un étage haute tension et un étage moyenne ou basse tension et dans lequel l'erreur est attribuée à l'étage haute tension, respectivement à l'étage moyenne ou basse tension, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence.

6. Procédé selon l'une des revendications 1 à 4, dans lequel les transformateurs de tension sont des transformateurs inductifs comprenant chacun un enroulement primaire et un enroulement secondaire et dans lequel l'erreur est attribuée à l'enroulement primaire, respectivement à l'enroulement secondaire, du transformateur de tension correspondant à celle des trois tensions efficaces déterminées qui est la plus éloignée de la tension efficace de référence lorsque celle des trois tensions efficaces déterminées qui est la plus éloignée de la tension efficace de référence est supérieure, respectivement inférieure, à la tension efficace de référence.

7. Procédé selon l'une des revendication 1 à 6, comprenant la réitération desdites étapes et la génération d'une alerte lorsqu'une erreur de l'un des transformateurs de tension est détectée lors de plusieurs itérations consécutives desdites étapes.

8. Procédé selon l'une des revendication 1 à 7, dans lequel la mesure de la tension secondaire de chacun des transformateurs de tension sur la fenêtre temporelle correspond à un ensemble d'échantillons numériques successifs chacun associé à un niveau de qualité correct.

9. Procédé selon l'une des revendications 1 à 8, dans lequel la détermination des trois tensions efficaces comprend la détection des passages à zéro de la tension secondaire mesurée pour chacun des transformateurs de tension sur la fenêtre temporelle.

10. Produit programme d'ordinateur comprenant des instructions qui, lorsque le programme est exécuté par un ordinateur, conduisent celui-ci à mettre en œuvre le procédé selon l'une des revendications 1 à 9.

11. Appareil de surveillance (30) de transformateurs de tension chacun connecté à l'une des phases d'une même ligne haute tension triphasée, comprenant un processeur configuré pour mettre en œuvre le procédé selon l'une des revendications 1 à 9.

12. Système de diagnostic (10) de défauts de transformateurs de tension chacun connecté à l'une des phases d'une même ligne haute tension triphasée, comprenant un convertisseur analogique-numérique (20) et un appareil de surveillance (30) selon la revendication 11, le convertisseur analogique-numérique étant couplé, d'une part, à un secondaire de chacun des transformateurs de tension et, d'autre part, audit appareil de surveillance.

13. Poste électrique haute tension comprenant des transformateurs de tension chacun connecté à l'une des phases d'une même ligne haute tension triphasée et un système de diagnostic selon la revendication 12 ou un appareil de surveillance selon la revendication 11.

**Patentansprüche**

1. Verfahren zur Überwachung von Spannungstransformatoren (TCT, TTa), die jeweils an eine der Phasen (Pa, Pb, Pc) derselben dreiphasigen Hochspannungsleitung angeschlossen sind, das die folgenden Schritte umfasst:

- Ermitteln, aus einer Messung einer Sekundärspannung jedes der Spannungstransformatoren über ein Zeitfenster, einer Unipolar-Spitzenspannung ($V_{HM}$) und von drei Effektivspannungen ($V_{eff}(Va)$, $V_{eff}(Vb)$, $V_{eff}(Vb)$), die jeweils der Effektivspannung der Sekundärspannung (Va, Vb, Vc) eines der Spannungstransformatoren entsprechen;
- Ermitteln einer Referenz-Effektivspannung aus den drei ermittelten Effektivspannungen;
- wenn die Unipolar-Spitzenspannung einen ersten Schwellenwert überschreitet:

  ◦ Ermitteln einer Abweichung zwischen der Referenz-Effektivspannung und der der drei ermittelten Effektivspannungen, die am weitesten von der Referenz-Effektivspannung entfernt ist;
  ◦ Erkennen eines Fehlers des Spannungstransformators, der dem der drei ermittelten Effektivspannungen entspricht, die am weitesten von der Referenz-Effektivspannung entfernt ist, wenn die Abweichung einen zweiten Schwellenwert überschreitet.

2. Verfahren nach Anspruch 1, wobei die Ermittlung der Referenz-Effektivspannung die Ermittlung der beiden Effektivspannungen, welche die geringste relative Abweichung von den drei ermittelten Effektivspannungen aufweist und die Berechnung des Mittelwerts dieser beiden Effektivspannungen umfasst.

3. Verfahren nach einem der Ansprüche 1 und 2, wobei der erste Schwellenwert ein Bruchteil der Referenz-Effektivspannung ist.

4. Verfahren nach einem der Ansprüche 1 bis 3, wobei der zweite Schwellenwert mit dem ersten Schwellenwert identisch ist.

5. Verfahren nach einem der Ansprüche 1 bis 4, wobei die Spannungstransformatoren jeweils einen kapazitiven Spannungsteiler oder einen kapazitiv/resistiven Spannungsteiler integrieren, der eine Hochspannungsstufe und eine Mittel- oder Niederspannungsstufe umfasst und wobei der Fehler der Hochspannungsstufe beziehungsweise der Mittel- oder Niederspannungsstufe des Spannungstransformators zugeordnet wird, der derjenigen der drei ermittelten Effektivspannungen entspricht, die am weitesten von der Referenz-Effektivspannung entfernt ist, wenn diejenige der drei ermittelten Effektivspannungen, die am weitesten von der Referenz-Effektivspannung entfernt ist, größer beziehungsweise kleiner als die Referenz-Effektivspannung ist.

6. Verfahren nach einem der Ansprüche 1 bis 4, wobei die Spannungstransformatoren induktive Wandler sind, die jeweils eine Primärwicklung und eine Sekundärwicklung umfassen, und wobei der Fehler der Primärwicklung beziehungsweise der Sekundärwicklung des Spannungstransformators zugeordnet wird, der derjenigen der drei ermittelten Effektivspannungen entspricht, die am weitesten von der Referenz-Effektivspannung entfernt ist, wenn diejenige der drei ermittelten Effektivspannungen, die am weitesten von der Referenz-Effektivspannung entfernt ist, größer beziehungsweise kleiner als die Referenz-Effektivspannung ist.

7. Verfahren nach einem der Ansprüche 1 bis 6, das die Reiteration der Schritte und das Auslösen eines Alarms umfasst, wenn während mehrerer aufeinanderfolgender Iterationen der Schritte ein Fehler in einem der Spannungstransformatoren festgestellt wird.

8. Verfahren nach einem der Ansprüche 1 bis 7, wobei die Messung der Sekundärspannung jedes der Spannungstransformatoren über das Zeitfenster einer Reihe aufeinanderfolgender digitaler Abtastwerte entspricht, die jeweils einem korrekten Qualitätsniveau zugeordnet sind.

9. Verfahren nach einem der Ansprüche 1 bis 8, wobei die Ermittlung der drei Effektivspannungen die Erkennung der Nulldurchgänge der gemessenen Sekundärspannung für jeden der Spannungstransformatoren über das Zeitfenster umfasst.

10. Computerprogrammprodukt, das Anweisungen umfasst, die, wenn das Programm von einem Computer ausgeführt wird, diesen veranlassen, das Verfahren nach einem der Ansprüche 1 bis 9 durchzuführen.

11. Überwachungseinrichtung (30) für Spannungstransformatoren, die jeweils an eine der Phasen derselben dreiphasigen Hochspannungsleitung angeschlossen sind, umfassend einen Prozessor, der dazu konfiguriert ist, das Verfahren nach einem der Ansprüche 1 bis 9 durchzuführen.

12. System zur Diagnose (10) von Fehlern in Spannungstransformatoren, die jeweils an eine der Phasen derselben dreiphasigen Hochspannungsleitung angeschlossen sind, umfassend einen Analog-Digital-Wandler (20) und eine Überwachungseinrichtung (30) nach Anspruch 11, wobei der Analog-Digital-Wandler einerseits mit einer Sekundärseite jedes Spannungstransformators und andererseits mit der Überwachungseinrichtung gekoppelt ist.

13. Hochspannungs-Schaltstation, die Spannungstransformatoren umfasst, die jeweils an eine der Phasen derselben dreiphasigen Hochspannungsleitung angeschlossen sind, und ein Diagnosesystem nach Anspruch 12 oder eine Überwachungseinrichtung nach Anspruch 11.

**Claims**

1. A method for monitoring voltage transformers (TCT, TTa) each connected to one of the phases (Pa, Pb, Pc) of one and the same three-phase high-voltage line, comprising the following steps:

   - based on a measurement of a secondary voltage of each of the voltage transformers over a time window, determining a peak homopolar voltage ($V_{HM}$) and three root-mean-square voltages ($V_{eff}(Va)$, $V_{eff}(Vb)$, $V_{eff}(Vb)$) each corresponding to the root-mean-square voltage of the secondary voltage (Va, Vb, Vc) of one of the voltage transformers;
   - determining a reference root-mean-square voltage based on the three determined root-mean-square voltages;

- when the peak homopolar voltage exceeds a first threshold:

    ○ determining a deviation between the reference root-mean-square voltage and the one of the three determined root-mean-square voltages that is the furthest from the reference root-mean-square voltage;
    ○ detecting an error of the voltage transformer corresponding to the one of the three determined root-mean-square voltages that is the furthest from the reference root-mean-square voltage when said deviation is greater than a second threshold.

2. The method as claimed in claim 1, wherein the determining of the reference root-mean-square voltage comprises the determining of the two root-mean-square voltages having the smallest relative deviation from among the three determined root-mean-square voltages and the computing of the average of said two root-mean-square voltages.

3. The method as claimed in one of claims 1 and 2, wherein the first threshold is a fraction of the reference root-mean-square voltage.

4. The method as claimed in one of claims 1 to 3, wherein the second threshold is identical to the first threshold.

5. The method as claimed in one of claims 1 to 4, wherein the voltage transformers each have an integrated capacitive voltage divider or a resistive-capacitive voltage divider comprising a high-voltage stage and a medium- or low-voltage stage and wherein the error is attributed to the high-voltage stage, or the medium- or low-voltage stage respectively, of the voltage transformer corresponding to the one of the three determined root-mean-square voltages that is the furthest from the reference root-mean-square voltage, when the one of the three determined root-mean-square voltages that is the furthest from the reference root-mean-square voltage is greater, or respectively less than, the reference root-mean-square voltage.

6. The method as claimed in one of claims 1 to 4, wherein the voltage transformers are inductive transformers each comprising a primary winding and a secondary winding and in which the error is attributed to the primary winding, or the secondary winding respectively, of the voltage transformer corresponding to the one of the three determined root-mean-square voltages that is the furthest from the reference root-mean-square voltage when the one of the three determined root-mean-square voltages that is the furthest from the reference root-mean-square voltage is greater than, or respectively less than, the reference root-mean-square voltage.

7. The method as claimed in one of claims 1 to 6, comprising the reiterating of said steps and the generating of an alert when an error in one of the voltage transformers is detected during several consecutive iterations of said steps.

8. The method as claimed in one of claims 1 to 7, wherein the measuring of the secondary voltage of each of the voltage transformers over the time window corresponds to a set of successive digital samples each associated with an adequate quality level.

9. The method as claimed in one of claims 1 to 8, wherein the determining of the three root-mean-square voltages comprises the detecting of the zero crossings of the secondary voltage measured for each of the voltage transformers over the time window.

10. A computer program product comprising instructions which, when the program is executed by a computer, lead it to implement the method as claimed in one of claims 1 to 9.

11. An apparatus (30) for monitoring voltage transformers each connected to one of the phases of one and the same three-phase high-voltage line, comprising a processor configured to implement the method as claimed in one of claims 1 to 9.

12. A system (10) for diagnosing faults in voltage transformers each connected to one of the phases of one and the same three-phase high-voltage line, comprising an analog-to-digital converter (20) and a monitoring apparatus (30) as claimed in claim 11, the analog-to-digital converter being coupled, on the one hand, to a secondary of each of the voltage transformers and, on the other hand, to said monitoring apparatus.

13. A high-voltage substation comprising voltage transformers each connected to one of the phases of one and the same three-phase high-voltage line and a diagnosing system as claimed in claim 12 or a monitoring apparatus as claimed in claim 11.

Fig. 1

Fig. 2

Fig. 3

EP 4 577 842 B1

## RÉFÉRENCES CITÉES DANS LA DESCRIPTION

**Documents brevets cités dans la description**

- WO 2014162020 A1
- WO 2014162021 A1
- CN 108318762 A